## Europäisches Patentamt

## European Patent Office

## Office européen des brevets

(11) Numéro de publication: **0 311 502**
**A1**

## DEMANDE DE BREVET EUROPEEN

(21) Numéro de dépôt: **88402501.6**

(22) Date de dépôt: **04.10.88**

(51) Int. Cl.⁴: **G 06 F 15/06**
G 11 C 11/54, G 11 C 11/22

(30) Priorité: **09.10.87 FR 8713961**

(43) Date de publication de la demande:
**12.04.89 Bulletin 89/15**

(84) Etats contractants désignés: **DE FR GB NL**

(71) Demandeur: **THOMSON-CSF**
**173, Boulevard Haussmann**
**F-75379 Paris Cédex 08 (FR)**

(72) Inventeur: **de Chambost, Emmanuel**
**THOMSON-CSF SCPI 19, avenue de Messine**
**F-75008 Paris (FR)**

**Micheron, François**
**THOMSON-CSF SCPI 19, avenue de Messine**
**F-75008 Paris (FR)**

**Vallet, François**
**THOMSON-CSF SCPI 19, avenue de Messine**
**F-75008 Paris (FR)**

**Vignolle, Jean-Michel**
**THOMSON-CSF SCPI 19, avenue de Messine**
**F-75008 Paris (FR)**

(74) Mandataire: **Lincot, Georges et al**
**THOMSON-CSF SCPI 19, avenue de Messine**
**F-75008 Paris (FR)**

(54) **Réseau neuronal programmable à polymère ferroélectrique.**

(57) Le réseau comprend une pluralité d'éléments de mémoire (Mij) à polymère ferroélectrique disposés suivant une organisation matricielle aux croisements d'électrodes de lignes ($5_1$ à $5_m$) et de colonnes ($4_1$ à $4_n$). Chaque élément de mémoire (Mij) mémorise un coefficient synaptique $a_{ij}$ du réseau qui peut être restitué par effet pyroélectrique sur la colonne ($4_j$) correspondante du réseau. Des circuits amplificateurs ($8_1$ à $8_n$) reliés respectivement aux colonnes ($4_1$ à $4_n$) fournissent une tension qui est égale à la somme affectée d'un signe des produits des coefficients synaptiques ($a_{ij}$) par des composantes de tension ($E_{ei}$) appliquées sur chacune des lignes du réseau.

Application : techniques de l'intelligence artificielle.

Fig. 2

Bundesdruckerei Berlin

## Description

### Réseau neuronal programmable à polymère ferroélectrique

La présente invention concerne un réseau neuronal programmable à polymère ferroélectrique.

Les réseaux neuronaux désignent dans les techniques développées dans le domaine connu de l'intelligence artificielle des circuits électriques capables de réaliser des transformations sur des vecteurs ayant un nombre élevé de composantes. De nombreux exemples de réalisation de ces circuits sont connus par exemple de l'article de JJ Hopfield and DW Tank intitulé ≪ "Neural" Computation of Decisions in Optimization Problems ≫, publié dans la revue Biological Cybernetics 52 141 152 (1985) ou encore de l'article intitulé "A CMOS Implementation of a Neural Network Model" ayant pour auteurs Hans P. Graf et Paul de Vegvar publié par AT et T Bell Laboratories, Holmdel, NJ 07733.

L'objet de ces réseaux est de réaliser des opérations de la forme :

$$|V_s| = 1.|A_{ij}| \, |V_e|$$

où $|V_e|$ est un vecteur d'entrée à N composantes $V_{ei}$, telle que $V_{ei} \, \varepsilon \{-1, +1\}$, $|V_s|$ est un vecteur de sortie à M composantes $V_{sj}$ telle que $V_{sj} \, \varepsilon \, -1, +1$ et où $|A_{ij}|$ est une matrice de NxM coefficients positifs ou négatifs.

1. $|A_{ij}|$ désigne l'opération qui à un vecteur d'entrée $|V_e|$ fait correspondre un vecteur de sortie $|V_s|$ tel que :

$$V_{sj} = \text{sign} \left( \Sigma \,^{N}_{i=1} \, a_{ij} \, V_{ei} \right)$$

avec la convention que :

sign (n) = 1 si x > 0
sign (n) = -1 si x < 0

Les coefficients $a_{ij}$ sont appelés "coefficients synaptiques ou "poids synaptiques".

Selon les modes de réalisation connus, le calcul de l'opération $\Sigma^{i=n}_{i=1} \, a_{ij}. V_{ei}$ est réalisé de façon analogique, au moyen d'un circuit amplificateur à gain très élevé relié à un réseau de résistances. Les résistances du réseau sont reliées par une de leurs extrémités à l'entrée du circuit amplificateur, chaque coefficient $a_{ij}$ étant représenté par la valeur d'une résistance du réseau. On obtient ainsi un réseau neuronal composé d'un neurone, formé par le circuit amplificateur et de synapses, formés par les résistances. Toujours selon cette configuration, le signe de chaque coefficient synaptique $a_{ij}$ peut être déterminé en polarisant par une tension +u ou -u l'extrémité de la résistance correspondant à ce coefficient qui n'est pas relié à l'entrée du circuit amplificateur.

L'obtention d'un opérateur matriciel peut alors être obtenu en associant de la même façon plusieurs amplificateurs avec leur réseau de résistances. Cependant cette association devient industriellement peu viable lorsque le nombre des composantes des vecteurs traités est très grand, au delà par exemple de mille. Il est clair, dans ces conditions, que même en usant des techniques de réalisation de circuits intégrés à haute intégration les plus avancées, il n'est pas possible d'intégrer sur un même substrat $10^6$ résistances de valeurs différentes associées à 1000 amplificateurs.

Il est également clair qu'une solution purement numérique à ce problème ne peut également convenir car le processeur idéal devrait pouvoir traiter $10^6$ opérations par cycle élémentaire de calcul et qu'aucun processeur ne peut réaliser actuellement une telle performance.

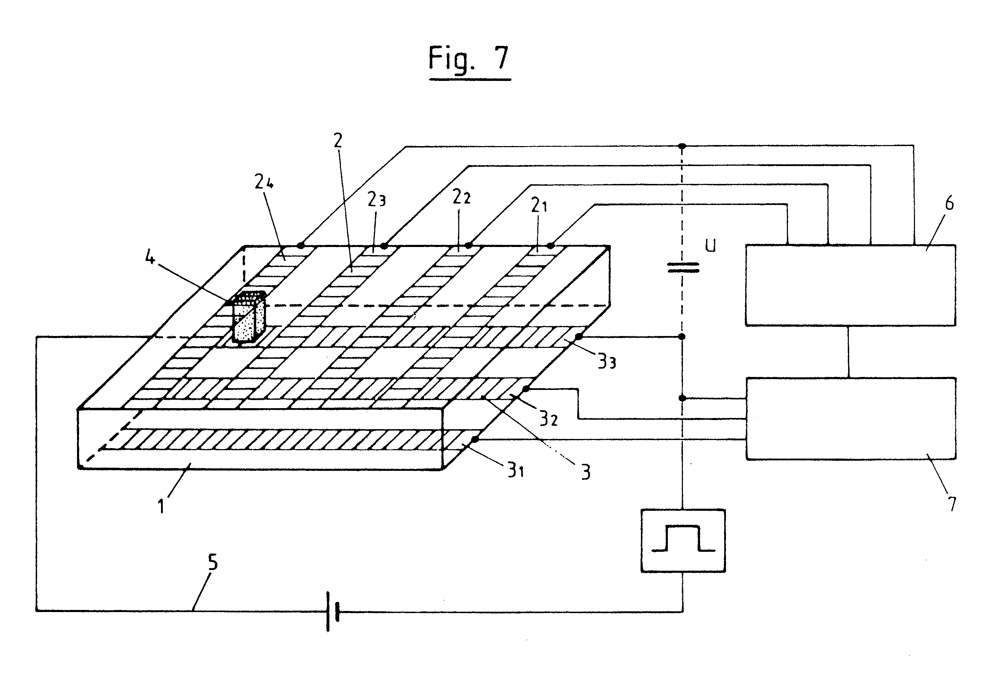

On connaît d'autre part un dispositif de mémorisation à éléments ferroélectriques polarisables, par la publication de brevet européen 0166938. Comme représenté en figure 7, ce document décrit notamment un système d'écriture et de lecture d'une telle mémoire, constituée d'une couche 1 en matériau électriquement polarisable, flanquée d'un jeu 2,3 de bandes conductrices parallèles $2_1$, $2_2$, ... ; $3_1$, $3_2$,..., sur sa face supérieure et sur sa face inférieure. Les deux jeux de bandes conductrices sont disposés à 90° l'un par rapport à l'autre, de façon à former une pluralité de points d'intersection définissant chacun une cellule de stockage 4.

L'opération d'écriture sur une cellule 4 s'effectue en établissant une tension entre la bande conductrice de ligne $3_3$ et la bande conductrice de colonne $2_4$ correspondantes. L'opération de lecture s'effectue par effet piézoélectrique ou pyroélectrique. Dans ce dernier cas, il est notamment proposé d'établir des impulsions de courant de chauffage dans chaque bande conductrice $3_i$, et de recueillir les signaux induits par les cellules correspondantes, en parallèle sur chacune des bandes conductrices perpendiculaires $2_1$, ... $2_4$. L'ensemble des cellules peut ainsi être exploré par chauffage successif de chacune des bandes $3_1...3_4$ sous commande d'un multiplexeur 7.

Ce dispositif connu est très loin d'être conçu ou adapté pour la réalisation de réseaux neuronaux :
- il ne permet pas d'introduire les valeurs $V_{ei}$ des composantes du vecteur d'entrée $V_e$, ni d'effectuer les produits $a_{ij}.V_{ei}$ ;
- il n'est pas conçu pour réaliser les opérations d'addition permettant d'obtenir chacune des composantes $V_{sj}$ du vecteur résultant $V_s$.

Le but de l'invention est de pallier les inconvénients et carences précités.

A cet effet, l'invention a pour objet un réseau neuronal programmable à polymère ferroélectrique caractérisé en ce que chaque synapse du réseau est formé par un élément de mémoire à polymère ferroélectrique pour la mémorisation d'un coefficient synaptique $a_{ij}$, sous la forme d'une charge électrique $q_{ij}$, et en ce que les éléments de mémoire $a_{ij}$ d'une même colonne j sont reliés ensemble par un même conducteur pour permettre l'écoulement de l'ensemble des charges électriques générées par effet pyroélectrique au niveau de chaque élément de mémoire du réseau lorsqu'une partie arbitraire de l'ensemble des éléments de mémoire de la colonne j est chauffée.

L'invention a pour principal avantage qu'elle permet la réalisation de réseaux de neurones artificiels par une simple mise en oeuvre des techniques connues de réalisation des circuits en micro-électrique. Les cubes de polymère ferroélectrique portant les différents synapses sont disposés matriciellement entre deux couches successives de neurones pour permettre la connexion entre ces neurones. L'information relative aux coefficients synaptiques de ces neurones est stockée grâce au cycle d'hystérésis du polymère ferroélectrique et l'effet pyroélectrique permet de faire la sommation des états de tous les neurones d'entrée, pondérés par les coefficients synaptiques.

D'autres caractéristiques et avantages de l'invention apparaîtront ci-après grâce à la description qui va suivre faite en regard des dessins annexés qui représentent :

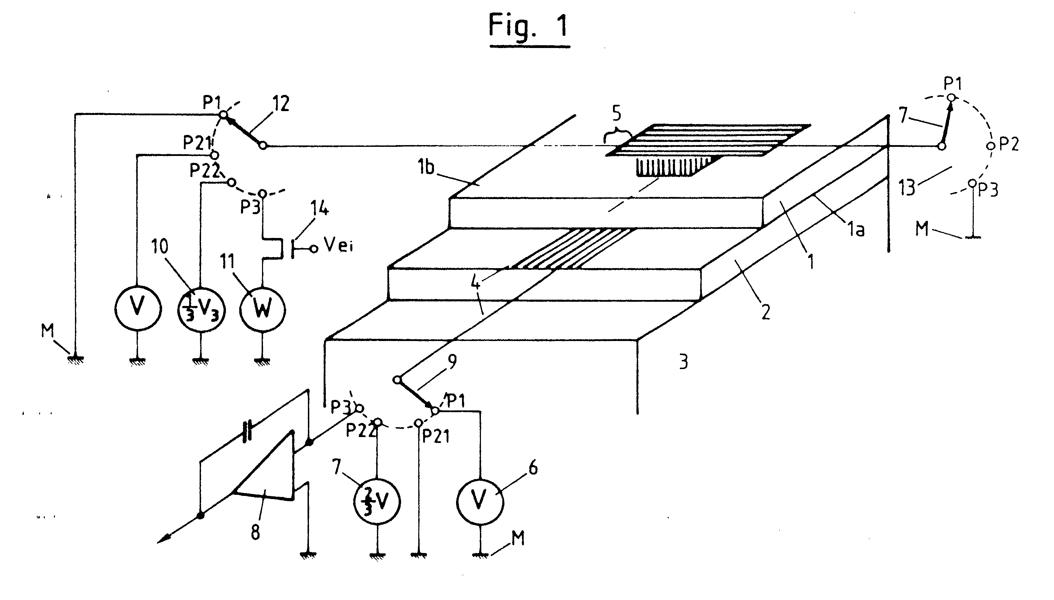

. la figure 1 l'organisation d'un élément de mémoire à polymère ferroélectrique selon l'invention ;

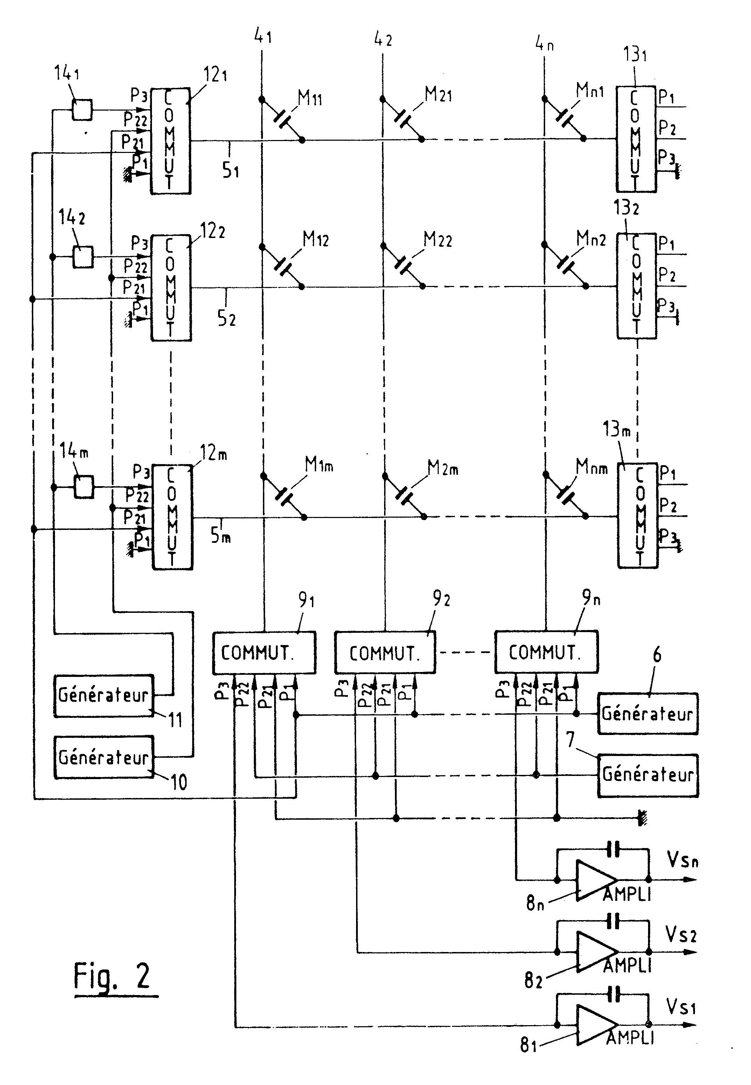

. la figure 2 un mode d'assemblage de plusieurs éléments de mémoire selon la figure 1 pour former un plan de mémoire à adressage matriciel ;

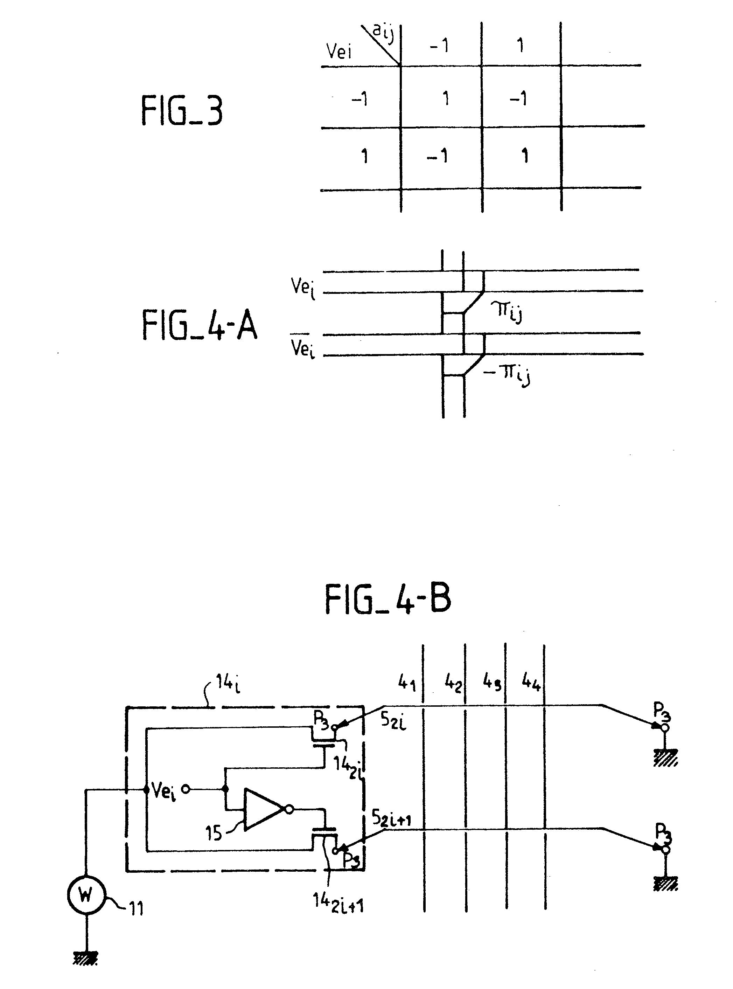

. la figure 3 une table de vérité de l'opération de multiplication $a_{ij}V_{ei}$ selon l'invention ;

. la figure 4 un dédoublement des lignes horizontales de l'organisation matricielle de la mémoire pour l'application de coefficients synaptiques positifs ou négatifs ;

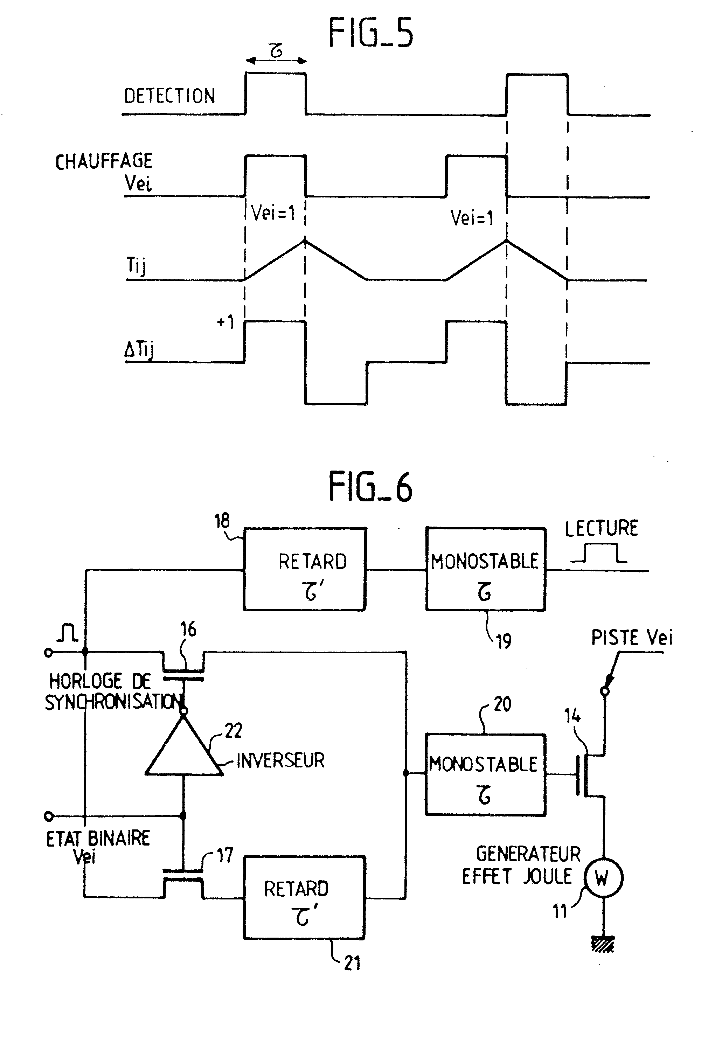

. la figure 5 un diagramme des temps représentant un mode d'excitation des éléments de mémoire sans dédoublement des pistes horizontales ;

. la figure 6 un mode de réalisation d'un séquenceur pour la génération des signaux représentés à la figure 5 ;

. la figure 7 un mode de réalisation connu d'une mémoire ferroélectrique ;

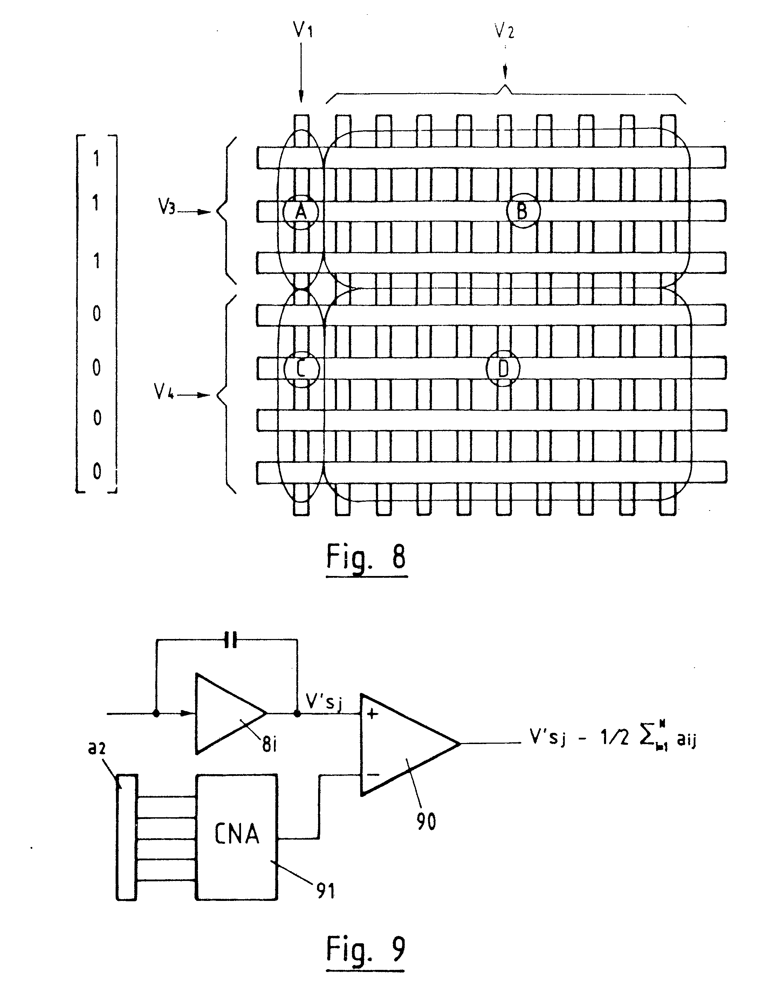

. la figure 8 un schéma illustrant le procédé d'enregistrement du réseau de l'invention ;

. la figure 9 un schéma illustrant un circuit spécifique de lecture du réseau.

L'élément de mémoire et de connexion qui est représenté à la figure 1 et qui sert de base à la réalisation matricielle d'un réseau de neurone selon l'invention, comprend un support d'enregistrement 1 formé par une couche mince d'un polymère ferroélectrique de type P (VF₂/TrFE) recouvrant une surface 2 d'une galette de silicium 3 préalablement oxydée. La couche mince 1 de polymère est déposée par une méthode connue sous le nom de "spin coating" dans le langage anglo-saxon ou encore sous la désignation française de dépôt à la tournette. Cette méthode permet d'obtenir des épaisseurs de polymère inférieures à $10^{-6}$ mètre et des temps de commutation du matériau sur son cycle d'hystérésis voisins d'une centaine de nanosecondes. Un autre avantage est que la couche mince qui est ainsi obtenue peut être chauffée très rapidement par un apport thermique appliqué sur leurs surfaces. Comme la diffusibilité thermique est pour ces polymères de $5.10^{-8}m^2s^{-1}$ on obtient pour une épaisseur de couche $10^{-6}$ m un temps de propagation de l'onde thermique dans l'épaisseur du matériau d'environ $5.10^{-6}$ s.

La couche de ferroélectrique nécessitée pour le stockage de l'information peut être constituée d'autres matériaux ferroélectriques que les polymères de type P(VF₂/TᵣFE) dans la mesure où l'on sait déposer ces matériaux en couche mince, typiquement d'une épaisseur inférieure au micron pour que le temps de diffusion thermique ne soit pas excessif et dans la mesure où le champ électrique de claquage est très supérieur au champ coercitif.

Ce peut être notamment le cas de la famille des matériaux ferroélectriques connue sous le nom de PZT (Plomb, zirconate, titanate) et de leurs dérivées. Les techniques de dépôt ont été mises au point pour les besoins des mémoires ferroélectriques appelées aussi FERRAM. La technique de dépôt de ces couches peut être la pulvérisation (sputtering).

L'électrode 4 est déposée par métallisation ou tout procédé équivalent sur la surface d'oxyde de silicium 2 de manière à être en contact avec une face 1a du support d'enregistrement 1. L'électrode 5 est déposée sur l'autre face 1b parallèle à la face 1a du support 1.

L'électrode 4 est couplée à un générateur d'effacement 6, à un générateur d'enregistrement 7 et à un amplificateur de lecture 8 au travers d'un commutateur 9 à quatre positions. L'électrode 5 est couplée, par une extrémité au circuit de masse M, à un générateur d'enregistrement 10 et à un générateur de lecture 11 au travers d'un commutateur 12 à quatre positions et par son autre extrémité au circuit de masse M de référence des potentiels de l'élément mémoire au travers d'un commutateur 13 à trois positions. Le couplage du générateur 11 à l'électrode 5 est validé par une porte analogique 14. Cette porte est commandée par une composante Vei du vecteur appliqué à l'élément de mémoire.

L'effacement de l'élément de mémoire est réalisé en plaçant les commutateurs 9, 12 et 13 dans la position P1. Dans cette position, le générateur 6 applique une impulsion d'amplitude d'environ 10 volts pendant quelques microsecondes sur l'électrode 4 et une tension nulle, correspondant à celle du circuit de masse M est appliquée sur l'électrode 5.

L'enregistrement d'informations sur les éléments mémoire de la colonne 4i est obtenu dans la configuration suivante :

. le commutateur 9 de la colonne 4i est sur la position P21 ;

. le commutateur 9 de toutes les autres colonnes sont sur les positions P22 ;

. les commutateurs 12 et 13 des lignes 5 sont sur P21 ou P22 selon que l'on veut écrire un "1" ou un "-1" dans l'élément mémoire correspondant.

Le fonctionnement qui en résulte est le suivant, après écriture de "-1" sur la totalité de la matrice. Comme illustré en figure 8, on utilise quatre générateurs de tension V₁, V₂, V₃, V₄. Ces quatre tensions ont pour objet, par le jeu de leurs combinaisons, d'assurer une mise à jour sélective de chaque colonne i successivement, sans effacement des autres colonnes.

La mise à jour sélective de chaque colonne conduit à distinguer quatre types de zones dans la matrice :

- zone A, formée des éléments de mémoire devant prendre la valeur -1, dans la colonne mise à jour ;

- zone C, formée des éléments de mémoire devant prendre la valeur -1, dans la colonne mise à jour ;

- zone B, formée des autres éléments de mémoire de mêmes lignes que les éléments de mémoire de la zone A, et

- zone D, formée des autres éléments de mémoire de mêmes lignes que les éléments de mémoire de la zone B.

Sur la figure 8, la colonne mise à jour est la première colonne, et est chargée aux valeurs (1,1,1, -1, -1, -1, -1). Bien entendu, chaque colonne est successivement chargée, ce qui conduit à une distribution des zones B et D de part et d'autre de la colonne mise à jour, lorsque celle-ci ne se trouve pas à une extrémité de la matrice. De même, les zones A et C de la colonne mise à jour peuvent éclater en plusieurs portions alternées en fonction de l'alternance des valeurs -1 et 1 de chargement de chaque colonne.

Chacune des cellules de la matrice voit les tensions suivantes :

| tension vue par les pixels : | Résultats souhaités : | ce qui implique |
|---|---|---|
| Zone A $VA = V_3-V_1$ | "1" écrit | $V_3-V_1 > V_C$ |
| Zone B $VB = V_3-V_2$ | inchangé | $|V_3-V_2| < V_C$ |
| Zone C $VC = V_4-V_1$ | inchangé | $|V_4-V_1| < V_C$ |
| Zone D $VD = V_4-V_2$ | inchangé | $|V_4-V_2| < V_C$ |

$V_c$ est la tension de seuil nécessaire pour faire basculer la polarisation rémanente du ferroélectrique.

On peut prendre pour $V_1$, $V_2$, $V_3$ et $V_4$ n'importe quelle valeur respectant les contraintes de la colonne de droite.
Par exemple :
$V_3 = V$
$V_1 = 0$ volts
$V_4 = 1/3\ V_3$
$V_2 = 2/3\ V_3$

Ce choix minimise les tensions vues par chaque pixel B, C, D (les pixels voient $\pm\ 1/3\ V_3$).

Enfin, la lecture est effectuée en plaçant les commutateurs 9, 12 et 13 sur la position P3 ce qui a pour effet de faire passer un courant au travers de l'électrode 5 si l'entrée de la porte analogique 14 est au niveau logique 1. L'élévation de température à la surface 1b de la couche ferroélectrique du support 1 engendrée par effet Joule dans l'électrode 5 produit à la sortie de l'amplificateur de lecture 8 un signal positif ou négatif suivant l'état 1 ou zéro du signal mémorisé dans l'élément de mémoire. A titre d'exemple, une puissance d'environ $24.10^{-3}$ Watt appliquée pendant environ 5µs est généralement suffisante pour permettre l'obtention d'un rapport signal/bruit satisfaisant.

La structure qui vient d'être décrite d'un élément de mémoire et de connexion selon l'invention présente l'avantage qu'elle peut s'intégrer très facilement dans des ensembles plus vastes pour former par exemple, des plans matriciels de mémoire du type de celui qui est représenté à la figure 2.

Dans cet exemple, un plan matriciel de mémoire est réalisé sur une mince galette de silicium par un assemblage de n x m éléments de mémoire $M_{ij}$ du type décrit précédemment. Chaque élément $M_{ij}$ occupe une position de la matrice au croisement d'une électrode de colonne $4_i$ et de ligne $4_j$ avec $1 < i < n$ et $1 < j < m$. Suivant cette organisation, chaque électrode ligne $5_j$ relie n éléments de mémorisation au travers de deux commutateurs $12_j$ et $13_j$ et chaque électrode de colonne $4_i$ relie m éléments de mémorisation au travers d'un seul commutateur $9_i$. On note sur la figure 2 que pour une meilleure intégration de l'ensemble des éléments composant le plan de mémoire, les commutateurs $9_i$, $12_j$, $13_j$ peuvent être avantageusement remplacés par des circuits logiques de commutation qui peuvent être directement intégrés à la galette de silicium.

L'effacement du plan de mémoire est obtenu dans ces conditions en plaçant toutes les lignes $5_1$ à $5_n$ au potentiel zéro, et toutes les colonnes $4_1$ à $4_n$ à un potentiel V supérieur à un potentiel Vc. Vc sera de l'ordre de quelques dizaines de volts pour une épaisseur de PVF$_2$ de $10^{-6}$ m, et devra être appliqué pendant quelques µs. L'état uniforme ainsi obtenu correspond alors à une polarisation uniforme -Pr donnant un signal pyroélectrique positif à l'élévation de température, à laquelle peut être assignée une valeur de digit "-1".

En mode opératoire, les colonnes $4_1$ à 4n sont commutées à leurs amplificateurs de charge $8_1$ à 8n et les électrodes lignes sont commutées en position P3 sur leur générateur 11 au travers, comme sur la figure 1, de portes analogiques $14_1$ à $14_m$.

L'élévation de température à la surface du ferroélectrique, engendrée par effet Joule dans chaque électrode de ligne, produit un signal positif pour un digit "-1" et un signal négatif pour un digit "1". Les circuits de lecture peuvent être conçus pour traiter l'un de ces deux signaux comme s'il était nul et l'on revient alors aux signaux digitaux usuels.

Le dispositif qui vient d'être décrit présente deux intérêts :
. d'une part, le support de la mémorisation des coefficients synaptiques est réalisé par des points mémoires en polymères ferroélectriques.
. d'autre part, grâce à l'effet pyroélectrique, la connexion synaptique entre une ligne exécutée par une composante Vei du vecteur d'entrée et une colonne fournissant une composante Vj du vecteur de sortie est réalisée par ce même point mémoire.

Comme le signal de lecture est formé par une charge électrique Q déterminée par la relation
$Q = \pi\ \Delta\ T$ où $\Delta\ T$ est l'accroissement de température, et $\pi$ le coefficient pyroélectrique,
on obtient, si toutes les entrées $V_{ei}$ sont excitées en même temps, à l'entrée d'un neurone, une charge $Q_{ij}$ générée par chaque connexion telle que :
$Q_{ij} = \pi_{ij}\ \Delta\ T_i$

Sur l'ensemble d'une colonne, la charge globale générée est alors

$$Q_j = \sum_{i=1} Q_{ij}$$

La transformation de la charge électrique $Q_j$ en un niveau de potentiel $V_j$ et une discrimination $V_{sj} = \text{sign}(V_j)$ sont réalisées par chaque amplificateur de colonne $8_j$.

$\pi_{ij}$ est proportionnel à la polarisation rémanente stockée du point (i, j). Comme la polarisation peut varier de $-P_r$ à $+P_r$, $\pi_{ij}$ peut présenter des valeurs, négative, nulle ou positive.

Dès lors, le produit $a_{ij}.V_{ei}$ qui est à considérer est un produit qui vérifie la table de vérité de la figure 3. Cette table tient compte du fait que les cubes ferroélectriques ou éléments de mémoire sont toujours saturés dans un état haut ou dans un état bas.

Trois moyens principaux sont envisageables pour vérifier la table de vérité de la multiplication algébrique $a_{ij}.V_{ei}$ de la figure 3.

Le premier moyen qui est représenté aux figures 4A et 4B consiste à dédoubler chacune des lignes horizontales $5_i$ suivant deux lignes $5_{2i}$ et $5_{2i+1}$ pour que la connexion entre une ligne $5_{2i}$ excitée au potentiel $V_{ei}$ et une colonne $4_j$ soit toujours dans l'état électrique opposé à l'état électrique de la connexion entre la ligne excitée au potentiel $V_{ei}$ et la colonne $4_j$.

Si $V_{ei} = 1$ la ligne $5_{2i}$ qui est portée au potentiel $V_{ei}$ est chauffée et la ligne $5_{2i+1}$ portée au potentiel $V_{ei}$ n'est pas chauffée. Un dispositif $14_i$ d'excitation des lignes $5_{2i}$ et $5_{2i+1}$ est représenté à l'intérieur d'une ligne en pointillés à la figure 4B. Ce dispositif comprend deux portes $14_{2i}$ et $14_{2i+1}$ d'excitation des lignes $5_{2i}$ et $5_{2i+1}$ par le générateur 11, la porte $14_{2i}$ étant directement commandée par le niveau de potentiel du signal $V_{ei}$ et la porte $14_{2i+1}$ étant commandée par un niveau de potentiel inverse du signal $V_{ei}$ par un amplificateur 15.

Un second moyen, illustré par le diagramme de la figure 5 et le schéma de la figure 6 effectue une transposition temporelle du schéma spatial des figures 4A et 4B. Cette transposition consiste à éviter le dédoublement d'un point mémoire en son opposé, et pour réaliser une entrée $V_{ei} = -1$, à décaler une impulsion dans le temps, de sorte qu'au moment de la détection, chaque cube ferroélectrique ou élément de mémoire soit dans une phase de refroidissement.

Suivant le diagramme des temps de la figure 5, la période de lecture est typiquement de l'ordre de grandeur des temps de propagation de l'onde thermique dans la couche de polymère ferroélectrique, soit $e^2/4D$
où e est l'épaisseur du ferroélectrique
et D sa diffusivité thermique.

Un séquenceur correspondant est représenté à la figure 6. Il comprend un générateur à effet Joule 11 pour l'alimentation de chaque ligne au travers d'un transistor 13. Une horloge de synchronisation non représentée, applique un signal de synchronisation d'une part, aux entrées de deux interrupteurs de courant 16 et 17 et d'autre part, à l'entrée d'un dispositif à retard formé par deux dispositifs à retard 18 et 19 reliés en série et de retard respectifsets $\tau$ et $\tau'$. L'interrupteur de courant 16 transmet le signal de synchronisation sur l'entrée de commande du transistor 14 au travers d'un dispositif à retard 20 de retard égal à $\tau$ et l'interrupteur de courant 17 transmet le signal de synchronisation à l'entrée du dispositif à retard 20 au travers d'un dispositif à retard 21 de durée $\tau'$. L'interrupteur de courant 27 est commandé par l'état binaire égal à +1 du signal $V_{ei}$. L'interrupteur de courant 14 est commandé par l'état binaire égal à -1 du signal $V_{ei}$. Un amplificateur inverseur 32 permet d'inverser l'état du signal $V_{ei}$ pour la commande de l'interrupteur 16.

Un troisième moyen pour réaliser l'opération :

$$(a_{ij} V_{ei})$$

consiste à transposer des valeurs $V_{ei}$. Cette solution évite de dédoubler chaque ligne, en maintenant la synchronisation de tous les signaux d'entrée.

En effet si l'on pose $V'_{ei} = 1/2(V_{ei} + 1)$ :
comme $V_{ei} \varepsilon\{-1, +1\}$, on aura $V'_{ei} \varepsilon\{0, +1\}$,
d'où il vient :
$$(a_{ij} V_{ei}) = 2(\sum_i (a_{ij} V'_{ei}) - 1/2 \sum_i a_{ij}))$$

Le premier terme du 2ème membre représente directement la charge générée par effet pyroélectrique si
$\pi_{ij}$ est proportionnel à $a_{ij}$
$\Delta T_i$ est proportionnel à $V'_{ei}$

Le second terme ne dépend pas des signaux d'entrée, mais uniquement des coefficients synaptiques de la colonne. On peut donc calculer ce terme à la phase de l'enregistrement du réseau, le stocker par exemple sous la forme de son code binaire, et le transformer par des moyens classiques de conversion analogique-numérique à la phase de lecture.

La figure 9 représente un circuit mettant en oeuvre cette solution, et pouvant être mis en série avec chaque amplificateur $8_i$ de la figure 2. Le signal $V'_{sj}$ obtenu en sortie de l'amplificateur $8_i$ alimente une entrée d'un circuit additionneur 90. L'autre entrée du circuit additionneur 90 est connectée au CNA 91. Le CNA 91 convertit la valeur de $1/2 \sum a_{ij}$ stockée dans la mémoire 92. La sortie de l'additionneur $i$ 90 fournit enfin la valeur $V'_{sj} - \sum_{i=1}^{N} a_{ij}$ à partir de laquelle $V_{sj}$ est très simplement retrouvée.

## Revendications

1. Réseau neuronal programmable à polymère ferroélectrique caractérisé en ce que chaque synapse ($M_{ij}$) du réseau est formé par un élément de mémoire en matériau à couche mince ou d'autres matériaux ferroélectrique pour la mémorisation d'un coefficient synaptique $a_{ij}$, sous la forme d'une charge électrique $q_{ij}$, et en ce que les éléments de mémoire d'une colonne sont reliés ensemble par un même conducteur (4j) pour permettre l'écoulement de l'ensemble des charges électriques générées par effet pyroélectrique au niveau de chaque élément de mémoire du réseau lorsqu'une partie arbitraire de l'ensemble de mémoire (Mij) de la colonne j est chauffée.

2. Réseau selon la revendication 1 caractérisé en ce que chaque élément de mémoire (Mij) comprend un support d'enregistrement (1) constitué par un polymère ferroélectrique possédant une première (1a) et une deuxième (1b) faces parallèles entre elles, des moyens pour appliquer au moins un champ électrique de polarisation (6, 7, 10, 9, 13, 14) dans l'épaisseur du support entre la première et la deuxième face, constitués au moins par deux électrodes (4) disposées en croix respectivement sur la première et la deuxième face du support et des moyens (11, 12, 13) pour chauffer le support d'enregistrement au croisement des électrodes, et des moyens (8) pour recueillir le courant électrique dû à l'effet pyroélectrique engendré sur l'une des électrodes.

3. Réseau selon la revendication 2 caractérisé en ce que le film de polymère est un copolymère P (VF$_2$, VF$_3$) contenant 50 à 80 % de VF$_3$.

4. Réseau selon la revendication 3 caractérisé en ce que le film de polymère a une épaisseur d'environ $10^{-6}$ m.

5. Réseau selon l'une quelconque des revendications 2 à 4 caractérisé en ce qu'il comprend une pluralité d'électrodes disposées en lignes (5) et colonnes (4) suivant une organisation matricielle respectivement sur la première (1a) et la deuxième face (1b) du support.

6. Réseau selon la revendication 5 caractérisé en ce que les électrodes de lignes (5$_1$, 5$_m$) sont couplées à des circuits d'effacement (12), d'enregistrement (10), et de lecture (11) de chacun des éléments de mémoire situés au croisement des électrodes lignes et colonnes de la matrice.

7. Réseau selon la revendication 6 caractérisé en ce que l'effacement des éléments de mémoire est obtenu en plaçant les électrodes de lignes (5$_1$,... 5$_m$) correspondantes au potentiel 0 volts, et les électrodes de colonne (4$_1$, ... 4$_n$) correspondantes à un potentiel V supérieur à un potentiel Vc > 0 déterminé.

8. Réseau selon les revendications 6 et 7 caractérisé en ce que l'enregistrement au croisement d'une ligne (5j) et d'une colonne (4j) est effectué en plaçant l'électrode de colonne correspondante au potentiel zéro et l'électrode de ligne correspondante à un potentiel V > 0, pendant l'intervalle de temps déterminé.

9. Réseau selon l'une quelconque des revendications 5 à 8 caractérisé en ce que les électrodes de ligne sont dédoublées pour former des couples d'électrodes, les électrodes d'un couple étant excitées par des excitations électriques contraires.

10. Réseau selon l'une quelconque des revendications 6 à 8 caractérisé en ce que les circuits de lecture comprennent un générateur à effet Joule et des moyens de détection pour détecter les courants produits sur les électrodes de colonne (4j) en période de chauffage des éléments de mémoire (Mij) pour une polarité déterminée des signaux de lecture (Vei) sur les électrodes de colonne (4j) pour la période de refroidissement qui suit la période de chauffage des éléments de mémoire (Mij) lorsque les signaux de lecture (Vei) appliqués sur les électrodes de ligne ont une polarité inverse de la précédente.

11. Réseau selon l'une quelconque des revendications 6 à 8 caractérisé en ce que les circuits de lecture comprennent des moyens 92 de stockage d'une valeur (1/2 $\Sigma$ a$_{ij}$) représentative de la somme des coefficients synaptiques de chaque colonne, et des moyens 90, 91 d'addition pondérée de ladite valeur avec le courant électrique V'$_{sj}$ engendré par effet pyroélectrique sur l'électrode de colonne correspondante, de façon à obtenir une valeur finale :
V$_{sj}$ = 2(V'$_{sj}$ - 1/2 $\sum$ a$_{ij}$) $\varepsilon$ -1, + 1 .

12. Réseau selon la revendication 8 caractérisée en ce que l'enregistrement du réseau est effectué colonne par colonne, et en ce que, pour chaque colonne (j) en cours d'enregistrement, on établit simultanément :
- une tenson V$_1$ sur l'électrode de colone (4j) ;
- une tension V$_2$ sur toutes les autres électrodes de colonnes (4$_1$, ... 4$_{j-1}$, 4$_{j+1}$, ...4$_n$) ;
- une tension V$_3$ sur les électrodes de lignes 5$_k$ correspondant aux éléments de mémoire (M$_{kj}$) sur lesquels on veut enregistrer "1" ;
- une tension V$_4$ sur les électrodes de ligne 5$_l$ correspondant aux éléments de mémoire (M$_{lj}$) sur lesquels on veut enregistrer "-1" ;
les 4 tensions devant impérativement être soumises aux conditions V$_3$ -V$_1$ > V$_c$, |V$_3$-V$_2$| < V$_c$, |V$_4$-V$_1$| < V$_c$, |V$_4$ -V$_2$| < V$_c$ .

Fig. 1

Fig. 2

## FIG_3

|  $a_{ij}$  | -1 | 1 |  |
|-----|----|----|----|
| $V_{ei}$ |    |    |  |
| -1  | 1  | -1 |  |
| 1   | -1 | 1  |  |

## FIG_4-A

$V_{ei}$

$\pi_{ij}$

$\overline{V_{ei}}$

$-\pi_{ij}$

## FIG_4-B

$14_i$

$4_1$  $4_2$  $4_3$  $4_4$

$P_3$  $5_{2i}$

$14_{2i}$

$V_{ei}$

15

$5_{2i+1}$

$P_3$

$14_{2i+1}$

W  11

$P_3$

$P_3$

# FIG_5

# FIG_6

Fig. 7

EP 0 311 502 A1

Fig. 8

$$V'sj - 1/2 \sum_{i=1}^{N} a_{ij}$$

Fig. 9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 166 938 (BAYER AG)<br>* En entier *<br>--- | 1-8,10-12 | G 06 F 15/06<br>G 11 C 11/54<br>G 11 C 11/22 |
| Y | US-A-3 845 471 (REITBEOCK)<br>* Résumé; colonne 2, lignes 57-63; colonne 6, lignes 32-53; colonne 8, ligne 18 - colonne 9, ligne 18; figures 3,7 *<br>--- | 1-8,10-12 | |
| A | US-A-4 518 866 (CLYMER)<br>* Résumé; figure 1 *<br>--- | 1 | |
| Y | US-A-4 620 262 (OLSEN)<br>* Résumé; colonne 2, lignes 28-34 *<br>--- | 3,4 | |
| A | US-A-3 430 203 (CRAWFORD)<br>* Figures 1,2; résumé; colonne 4, lignes 30-36 *<br>--- | 1 | |
| A | TECHNIQUES DE L'INGENIEUR, référence (E-1870), 1985, pages 1-22; F. MICHERON: "Ferroélectricité"<br>* Tableaux I,II; figure 17 *<br>--- | 6-8,10 | |
| A | KYBERNETIK, vol. 2, no. 4, février 1965, pages 148-152; K. STEINBUCH: "Adaptive networks using learning matrices<br>* Figure 2 *<br>--- | 9 | |
| Y | EP-A-0 154 263 (HITACHI)<br>* Figures 6,8 *<br>--- | 11 | |
| Y | EP-A-0 103 170 (HITACHI)<br>* Figures 4,5,14 *<br>--- -/- | 11 | |

DOMAINES TECHNIQUES RECHERCHES (Int. Cl.4)

G 06 F
G 06 K
G 11 C
H 01 G
H 01 L

Le présent rapport a été établi pour toutes les revendications

| Lieu de la recherche | Date d'achèvement de la recherche | Examinateur |
|---|---|---|
| LA HAYE | 20-12-1988 | NETH C.M.F. |

Office européen

des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 169 258   (TANNAS Jr.) <br> * En entier * <br> --- | 12 | |
| X,P | FR-A-2 604 283   (THOMSON-CSF) <br> * En entier * <br> ----- | 1-8,10 | |
| | | | **DOMAINES TECHNIQUES RECHERCHES (Int. Cl.4)** |

Le présent rapport a été établi pour toutes les revendications

| Lieu de la recherche | Date d'achèvement de la recherche | Examinateur |
|---|---|---|
| LA HAYE | 20-12-1988 | NETH C.M.F. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P0402)